(19) Europäisches Patentamt
European Patent Office
Office européen des brevets

(11) **EP 4 657 083 B1**

(12) **EUROPEAN PATENT SPECIFICATION**

(45) Date of publication and mention
of the grant of the patent:
**01.07.2026 Bulletin 2026/27**

(21) Application number: **25161172.9**

(22) Date of filing: **01.03.2025**

(51) International Patent Classification (IPC):
*G01R 27/02* (2006.01)    *G01R 31/389* (2019.01)
*G01R 27/08* (2006.01)

(52) Cooperative Patent Classification (CPC):
**G01R 27/02; G01R 27/08; G01R 31/389**

(54) **SMALL IMPEDANCES MEASURING DEVICE**

MESSVORRICHTUNG FÜR KLEINE IMPEDANZEN

DISPOSITIF DE MESURE DE FAIBLES IMPÉDANCES

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **27.05.2024 CZ 20240216**

(43) Date of publication of application:
**03.12.2025 Bulletin 2025/49**

(73) Proprietor: **Ceske vysoke uceni technicke v Praze
160 00 Praha 6 - Dejvice (CZ)**

(72) Inventor: **PAPEZ, Vaclav
Praha 10 (CZ)**

(74) Representative: **Kratochvil, Vaclav
Patent and Trademark Office
P.O. Box 26
295 01 Mnichovo Hradiste (CZ)**

(56) References cited:
**WO-A1-2022/062599     US-A1- 2022 190 622
US-A1- 2024 027 533**

• **LEE YOUNG-NAM ET AL: "Fast-settling Onboard
Electrochemical Impedance Spectroscopy
System Adopting Quasi-linear-phase Band-pass
Filter", 2023 IEEE INTERNATIONAL
INSTRUMENTATION AND MEASUREMENT
TECHNOLOGY CONFERENCE (I2MTC), IEEE, 22
May 2023 (2023-05-22), pages 1 - 6, XP034377564,
DOI: 10.1109/I2MTC53148.2023.10176024**

EP 4 657 083 B1

# Description

## Technical Field

A design is developed that allows the complex impedance of electrical circuits and components to be evaluated accurately and with a small measurement signal load

## Background Art

A large number of different methods are used to measure complex impedance. For the lower frequency range of 0<f<100 MHz, absolute methods, bridge methods, phasor **UI** methods and methods with auto-balancing bridges can be considered the most important, see patent 309064.

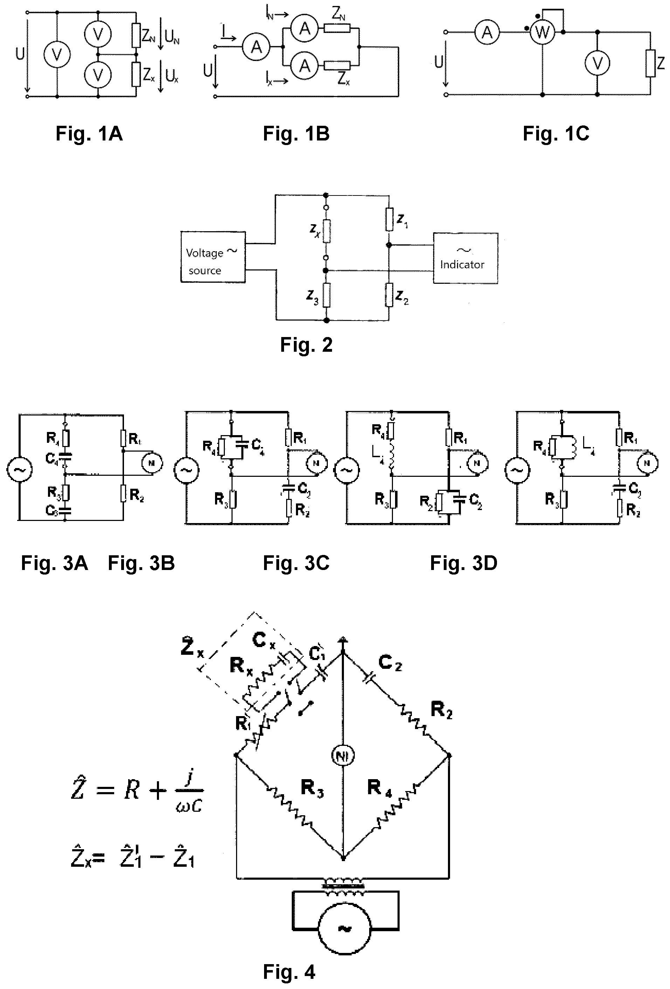

Absolute methods are based on determining the magnitudes of voltages, currents or powers in simple electrical circuits in which the impedance to be measured is connected, sometimes together with some normal impedance, a resistor. The three voltmeter, three ammeter and ammeter, voltmeter and wattmeter methods are known, see Figs.1A, 1B and 1C. The impedance is evaluated based on trigonometric analysis of voltage and current phasors in the circuit by calculating Z = Z .

The most noticeable drawbacks of these methods are the large influence of the power consumption of the measuring instruments on the measurement result, their frequency dependence, and their low accuracy, especially if one of the values of the voltages $U_n$ and $U_x$ , the currents $I_n$ and $I_x$ , or the magnitudes of the components of the measured complex impedance, is significantly smaller than the other. There are also modifications of the method that allow direct reading of the magnitude of the complex impedance and its components on the scales of pointer type measuring instruments, see Patent File No. 80036.

Bridge methods are methods that use electrical circuits of special design for measurement, which exhibit zero transmission at specific values of their circuit elements. This state, the balancing of a bridge, allows for an accurate comparison of the values of its circuit elements, which, in principle, is not dependent on the amplitude, often even the frequency, of the excitation signal and the accuracy of the indicating instrument. A typical connection of a general four-arm impedance bridge is shown in Fig. 2.

In case of balancing to zero voltage of the indicator, i.e. to the real balance, the relation $\widehat{Z_x} = \dfrac{\widehat{Z_1}\,\widehat{Z_3}}{\widehat{Z_2}}$ is valid for the impedances of its arms.

Although there are many possible bridge connections, in practice, only a few connections with the most advantageous properties are used. Typically, frequency independence of the bridge, mutually independent balancing for the components of the measured impedance and the possibility of balancing the bridge with variable resistors are required. The most frequently used connections are shown in Figs. 3A to 3D. For measuring capacitive impedance, it is a Schering's or De Sauty's bridge, for measuring inductive impedance, it is a Maxwell's Wien or Owen's bridge.

Modifications of these circuits are bridges in which the measured and balancing impedances are connected in the same branch of the bridge balanced by compensation, for example in the circuit according to Fig. 4.

The compensation bridge can also be used to measure impedances with which the primary bridge cannot be balanced. In the circuit of Fig. 4, the components of the measured impedance are determined as the differences of the components of the impedances $\hat{Z}_1$ and $\hat{Z}'_1$ with which the bridge is balanced without the included measured impedance $\hat{Z}_x$ and with the included measured impedance, and the measurement is possible for the impedance $\hat{Z}_x$ with arbitrarily small component sizes.

The sensitivity of the bridge is small when measuring small impedances, when other impedances in the bridge are large.

For example, for a general four-arm bridge according to Fig. 2, excited from a voltage source and with a non-loading indicator, the level of the signal indicated, near the balanced state in the diagonal, depending on the relative change of the measured impedance $\hat{Z}x$, can be expressed by the relations:

$$\Delta \widehat{U} = \widehat{U}_G \left\{ \frac{\widehat{Z_x}}{\widehat{Z_x}+\widehat{Z_3}} - \frac{\widehat{Z_x}-\Delta\widehat{Z_x}}{\widehat{Z_x}-\Delta\widehat{Z_x}+\widehat{Z_3}} \right\}$$

$$\Delta\widehat{U} \Big/ \widehat{U}_G \approx \frac{\Delta\widehat{Z_x}}{\widehat{Z_x}} \; \frac{1}{1+\widehat{Z_3}/\widehat{Z_x}}$$

The level of the indicated signal, relative to the level of the excitation signal, corresponds approximately to the relative change of the measured impedance, multiplied by the ratio of the measured impedance to the impedance in the opposite arm of the bridge.

Analogous characteristics are also found in transformer bridges, where a transformer or autotransformer is used as a precise voltage divider or current comparator.

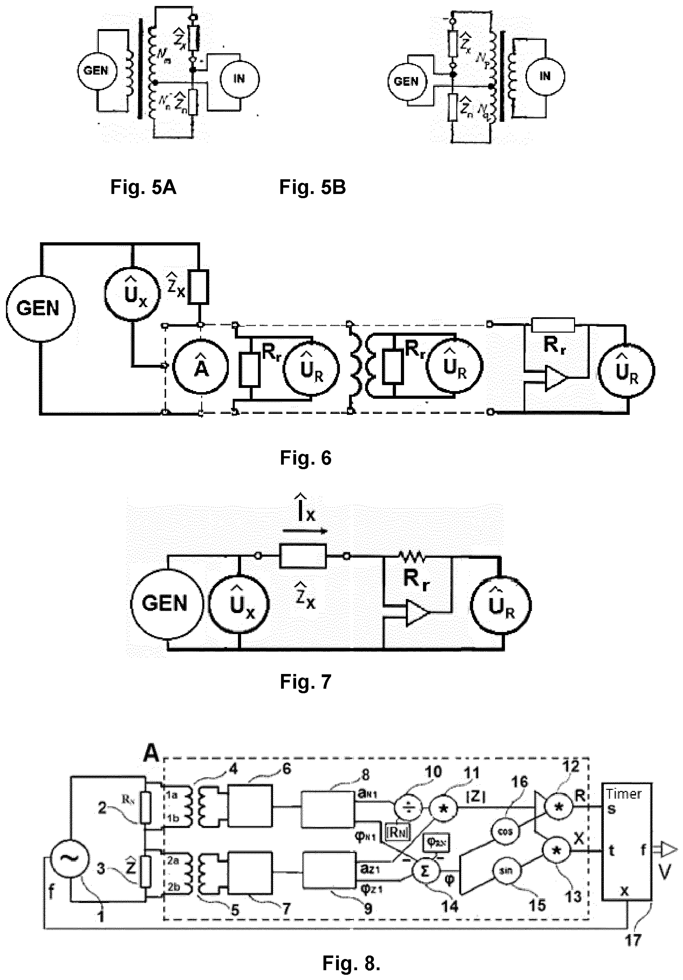

The basic connections of these bridges are shown in Fig. 5A and 5B. If $N_m$ and $N_n$ are the number of turns of the voltage transformer and $\hat{Z}_N$ is the reference impedance, the following applies to the voltage bridge when balancing:

$$\widehat{Z_x} = \frac{N_m}{N_n}\,\widehat{Z_n}$$

Analogously, if $N_p$ and $N_q$ are the number of turns of the current transformer and $\hat{Z}_N$ is the reference impedance, the following applies to the current bridge when balancing:

$$\widehat{Z_x} = \frac{N_p}{N_q} \widehat{Z_n}$$

The most noticeable disadvantage of all manually balanced bridges is the length of the measurement. It takes minutes to measure a single value, and hours to measure the frequency dependence.

A common disadvantage of all transformer bridges is the very difficult construction of a broadband transformer, especially if the bridge is to operate in the frequency range of tens of Hz or lower, where the transformer function is affected by the increase of magnetic induction in the ferromagnetic core and the non-linearity of the ferromagnetic.

Phasor methods are based on the determination of the magnitude of the measured impedance by the ratio of the voltage across the terminals of the measured impedance to the current passing through it. If one of the quantities is kept constant, it is enough to measure the other quantity. The phase angle of the measured impedance is determined by the phase shift between voltage and current.

The simplest measuring circuit is shown in Fig. 6. It consists of a measured impedance $\widehat{Z_x}$ , a GEN signal source and a phasor voltmeter $\widehat{U_x}$ and an ammeter A. The basic circuitry is modified to minimize the undesirable effects of parasitic couplings and the loading of the measuring circuit by measuring instruments on the measurement.

The voltmeter can be connected directly in parallel to the measured impedance. In case of negligible influence of voltage drop on the ammeter, the voltmeter is connected in parallel to the generator on the common ground bus with it.

The ammeter is usually implemented by a shunt resistor and voltmeter, a measuring transformer, a shunt resistor and voltmeter on the secondary winding of the measuring transformer, or a normal resistor, a compensating operational amplifier and a voltmeter, which is again connected to a common ground bus.

Such a circuit is referred to as an automatically balancing bridge with electrical feedback or a bridge with a transimpedance amplifier.

The current passing through the measured impedance is balanced by the current passing through the resistance $R_r$, which is controlled by the voltage at the amplifier output. The voltage at the node connecting the measured impedance and the resistance $R_r$ to the common ground bus is kept at a minimum value with an error proportional to the inverted gain value or the signal/noise (S/N) ratio at the amplifier output.

Another example of known connection is in Fig. 7. Here the sought impedance Zx can be determined directly from the ratio of phasors $\hat{U}_x$ and $\hat{U}_r$.

$$\widehat{Z_x} = \frac{\widehat{U_x}}{\widehat{U_r}} R_r$$

The sensitivity and accuracy of the measurement are determined decisively by the accuracy of the determination of the vector ratio $\hat{U}_x / \hat{U}_r$. Furthermore, the accuracy of the measurement corresponds to the deviation of the real impedance of the resistance $R_r$ from the value considered in the calculation.

The sensitivity and accuracy of measurement systems working with the above principle depends on the absolute value of the measured impedance, the frequency of measurement, and the signal level with which the measurement is made.

The systems work very well for measurements of linear impedances where the level of the measurement signal is not limited by non-linearity, impedances that are commensurate with the impedance of the balancing resistance $R_r$, and in the frequency range where operational amplifiers with high gain and minimal phase shift are available and where 1/f noise is not critical in signal processing.

Very good accuracy of approximately 0.05% for approximately $1<|Z|<10^6\Omega$ and $1^{-2}<f<10^5$ Hz deteriorates to values worse than 10%, especially for low impedances and at low frequencies - for $|Z|<10^{-2}\Omega$ and f<0.1 Hz.

Automatic bridges with servo-mechanical balancing are the most accurate impedance meters or impedance comparators. In the principle of the measuring circuit, these bridges correspond to conventional manually balanced bridges, whose manual balancing is replaced by servo-mechanical balancing. This is addressed by the paper Automatic Bridge Balance and Measurement of Resistance Using Microcontroller, Saubhik Panda, Anirban Kar, Bivash Mondal, Electrical Engineering, Heritage Institute of Technology, Kolkata, Volume V, Issue IV, April 2016 IJLTEMAS, ISSN 2278 - 2540 www.ijltemas, Page 14.

The output voltage of the bridge from its diagonal, displayed in manually balanced bridges by their indicator, is evaluated by a vector voltmeter, where it is decomposed into two orthogonal components. Their further processing is, at present, almost exclusively carried out by a digital control system, in which control signals for the actuators of the control system are generated on their basis, see the Manual for the presentation Title Fully automatic capacitance and loss factor tan □□measuring instrument, Type 2816 / Type 2816a and Type 2818 / Type 2818a.

A frequently used design principle of the servo-mechanical balancing bridge is the transformer bridge using an automatically controlled transformer or autotransformer as an adjustable inductive divider.

The best systems of this kind are used as equipment in metrology laboratories, see the paper A reconfigurable four terminal-pair digitally assisted and fully digital impedance ratio bridge, Jan Kučera, Jakub Kováč, I2MTC PAPER NO: 1570324967 1.

These systems achieve a sensitivity of 0.01ppm and an accuracy of 1ppm, while common laboratory devices achieve a sensitivity of a few ppm and an accuracy of 0.05% over impedance measuring ranges of approximately $1<|Z|<10^7\Omega$, mostly at fixed measuring frequencies. A specific characteristic of the bridges is their lengthy balancing process lasting several seconds.

The measurement of frequency dependence of small impedances of the order of units of $m\Omega$ in wide frequency ranges up to $1^{-2}<f<10^5$ Hz by all the above mentioned measurement systems is very complicated. Impedances $|Z|$ of the order of units of $m\Omega$ are at the edge of the measuring ranges of the measuring instruments or are not in the measuring ranges at all.

Modern available digital laboratory measuring instruments for measurements in the frequency range up to approximately 100 kHz are designed as automatically balanced bridges with electrical feedback. They show good accuracy of approximately 0.05% for approximately $1<|Z|<10^6\Omega$ and sensitivity of a few tens of ppm, which deteriorate to accuracy worse than 10% and sensitivity of a few tenths of %, especially for low impedances and at low frequencies - for $|Z|<10^{-2}\Omega$ and f<0.1 Hz.

The situation is particularly evident for systems when performing electrochemical impedance spectroscopy (EIS) of batteries, where the frequency dependence of the impedance of the order of $m\Omega$ is monitored in the frequency range of $10^{-2}$ to $10^4$ Hz and for non-linear bi-poles at terminal voltages not exceeding several mV.

Measurement of frequency dependences of impedances of the order of $m\Omega$, in the frequency range of $10^{-2}$ to $10^4$ Hz and for non-linear bi-poles at terminal voltages not exceeding several mV is typical in battery electrochemical impedance spectroscopy of batteries. This measurement method is widely used for non-destructive analysis and diagnostics of batteries, see article Electrical Characterization of Li-Ion Battery Modules for Second-Life Applications, authors Daniel Kehl, Torben Jennert, Frank Lienesch and Michael Kurrat.

From the measured dependence of battery impedance on frequency, it is possible to determine the parameters of the equivalent electrical circuit of the battery and the search parameters state of charge (SOC) and state of health (SOH) without discharging the battery.

However, the practical applicability of this procedure is often complicated by the low accuracy of the test and its lengthiness, as stated in the paper Novel online fitting algorithm for impedance-based state estimation of Li-ion Batteries, Conference Paper · October 2019, DOI: 10.1109/IECON.2019.8927338. According to the changes corresponding to the % units of the measured mean values, changes of the search parameters by tens of % are evaluated.

Tests carried out by the current most accurate systems take several tens of minutes, achieve an impedance measurement accuracy of 1 to 2% and allow the evaluation of battery parameters (R, X) with an accuracy of 5 to 10%. The low accuracy and lengthiness of this measurement procedure are the most serious shortcomings of this procedure, which practically precludes its use for service checks of multi-cell batteries with a capacity of hundreds of Ah.

US 2024/027533 A1 discloses a system for measuring a complex impedance associated with an arrangement of battery or fuel cells in an energy storage system. The system includes a controller, a current measurement device, and voltage measurement devices. The controller may determine a respective complex impedance of corresponding groups of the cells using a complex voltage measured by a respective voltage measurement device coupled across a corresponding group of the cells and a complex current measured by the complex current measurement device.

### Summary of the Invention

The above disadvantages are eliminated by the small impedances measuring device of the present proposal. The device contains a measuring signal generator, normal impedance $R_n$, tested impedance Z and a measuring block. The essence of the new solution is the new creation of a measuring block. A serial combination of normal impedance $R_n$ and tested impedance Z is connected in parallel to the generator. Parallel to the normal impedance $R_n$ is connected the primary winding of the first passive matching transformer, whose secondary winding is connected to the input of the first analog-to-digital converter, whose digital output is connected to the input of the first signal processor. Analogously, the primary winding of the second passive matching transformer is connected in parallel to the tested impedance Z. Its secondary winding is connected to the input of the second analog-to-digital converter, whose digital output is connected to the input of the second signal processor. The first and second passive matching transformers are identical and their conversion ratios are of the order of tens to hundreds. The output of the amplitude of the phasor of the 1st harmonic component of the voltage at the normal impedance from the first signal processor is connected via the calculation block $|R_{Nn}|/a_{N1}$, where $|R_{Nn}|$ is the magnitude of the normal impedance at the measurement frequency with the first input of the first multiplier. Its second input is connected to the output of the amplitude of the phasor of the 1st harmonic component of the voltage at the tested impedance from the second signal processor. The output of the first multiplier is connected to the first input of the second and third multipliers. The output of the argument of the phasor of the 1st harmonic component of the voltage at the normal impedance from the first signal processor is connected to the first input of the adder. Its second input is connected to the output of the argument of the phasor of the 1st harmonic component of the voltage at the tested impedance from the second signal processor and its third input is the input of a constant value on the measuring frequency representing the phase deviation of the normal impedance from the real value. The output of the adder is connected both to the input of the static functional sine generator, whose output is connected to the second input of the third multiplier, and to the input of the static functional cosine generator, whose output is connected to the second input of the second multiplier. The output of the real component of the tested impedance of the second multiplier is connected to the first input of the control timer, and the output of the imaginary component of the tested impedance of the third multiplier is connected to the second input of the control timer. The output of the control timer signal is connected to the control input of the generator. The frequency output and the system output code generated by converting signals from the first and second inputs of the control timer are connected to the output port and are output of the device.

The most significant advantage of this solution is the higher achievable measurement accuracy and faster measurement compared to commonly used methods, especially when measuring non-linear objects with impedances of the order of units of m$\Omega$, at voltages of several mV and in the low frequency range.

The advantage of the new solution is that the operational amplifiers usually used as input amplifiers in both voltage sensing branches of the impedance meter are replaced by passive matching transformers, and both voltage sensing branches of the measuring system are constructed as equivalent circuits. Matching transformers with conversion ratios in the order of tens to hundreds are connected in parallel to a normal resistor or the measured impedance by the primary winding and connected to the input terminals of analogue-to-digital converters by the secondary windings. In a situation that occurs when measuring small impedances of less than approximately 1 $\Omega$, where the internal resistance of the signal source connected to the input of the converter remains small to the noise resistance of the input gate of the converter even after the transformation, and the source of equivalent noise voltage remains decisive for the overall noise level at the input, the matching transformer improves the signal/noise ratio at the input in a ratio approximately equal to its voltage transformation ratio.

The advantage of this circuit is that by transforming the impedance it reduces the noise mismatch between the measured impedance and the connected input amplifier of the measuring instrument. As a result, the signal/noise distance at the input of the impedance meter is increased and the accuracy of the measurement is increased by approximately an order of magnitude.

Another advantage is that for all the non-neglected components of the $U_{N(tn)}$ and $U_{Z(tn)}$ signal approximations, the signals are retrospectively reconstructed and compared with the real data, and the signal/noise distance of the measurement is further evaluated according to the approximation error.

Also preferred is the embodiment in which the control timer of the measuring system is supplemented by a programmable unit that controls the frequency of the excitation generator according to its program, records and transmits to the output gate V or recorder of the measured values and thus allows automation of the measurement of impedance spectra.

In a preferred embodiment, the basic circuit is extended by a DC component separator placed upstream the measuring block. In this case, the generator is connected to the input of a power amplifier whose output port is connected both to the current terminals of the tested impedance and to the current terminals of the normal impedance via the first decoupling capacitor and the limiting resistor. Upstream the measuring block, the DC component separator is connected to the voltage terminals of the tested impedance and to the voltage terminals of the normal impedance, which consists of two equivalent isolating circuits, a voltage evaluation circuit at the normal impedance and a voltage evaluation circuit at the tested impedance allowing the measurement signal to be transmitted through both measuring branches from the measured impedance and the normal impedance to the evaluation circuits without DC voltage penetration.

For the voltage evaluation circuit at the tested impedance, one terminal of the second decoupling capacitor is connected to the first voltage terminal of the tested impedance, the second terminal of which is connected to the first switching contact of the relay, to the opening side of which the first charging resistor is connected by one terminal. The second terminal of the first charging resistor is connected to the second voltage terminal of the tested impedance, between which and the switching side of the switching contact of the relay antiparallel connected limiting diodes are connected which are connected in parallel to the first terminal to the second terminal of the primary winding of the second passive matching transformer of the measuring block.

In the voltage evaluation circuit at the normal impedance, one voltage terminal of the normal impedance is connected to the first terminal of a serial-parallel quadruplet of decoupling capacitors, which is connected by the middle terminal via the second charging resistor to the second voltage terminal of the tested impedance. With the second terminal, this quadruplet is connected to the second switching contact of the relay, to the opening side of which a third charging resistor is connected with one terminal. The second terminal of the third charging resistor is connected to the second voltage terminal of the normal impedance, between which and the switching side of the relay antiparallel connected limiting diodes are connected. These limiting diodes are connected in parallel to the terminals of the primary winding of the first passive matching transformer of the measuring block. A switch output is connected to the third input of the control timer. The switching signal output is connected to the relay coil.

In this arrangement, the device allows the measurement of impedances having a constant DC voltage between terminals, for example a battery pack.

Furthermore, the DC component separator allows you to safely control even the transient process that occurs when connecting the measuring system to the live object to be measured.

## Brief Description of the Drawings

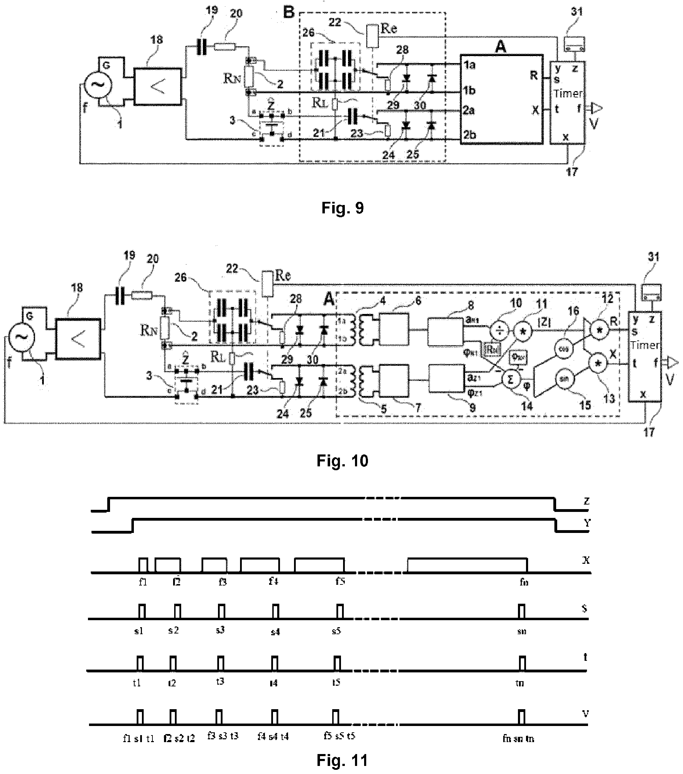

Figs. 1A to 1C, Fig. 2, Figs. 3A to 3D, Fig. 4, Figs. 5A, 5B, Fig. 6 and Fig. 7 show examples of known circuits of small impedances measuring devices, i.e. it is an illustration of the state of the art. The device for measuring small impedances according to the presented solution is shown in the basic variant in Fig. 8. Fig. 9 shows a variant for measuring impedances that have a DC voltage between the terminals, with the measuring block simply marked as a rectangle for clarity. The overall diagram of this variant of the battery impedance meter with the expanded measurement block is shown in Fig. 10. Fig. 11 shows signal waveforms on the gates of the variant control timer according to Fig. 10 when performing EIS battery electrochemical impedance spectroscopy.

## Exemplary Embodiments of the Invention

The basic circuit of the small impedances measuring device is shown in Fig. 8. The generator $1$ is connected in parallel to the serial combination of the normal impedance $R_n$ $2$ and the tested impedance $\hat{Z}$ $3$, which are connected to the measuring block $\underline{A}$. Parallel to the normal impedance $R_n$ $2$ is connected the primary winding of the first passive matching transformer $4$, whose secondary winding is connected to the input of the first analog-to-digital converter $6$, whose digital output is connected to the input of the first signal processor $8$ of the measuring block $\underline{A}$. Parallel to the tested impedance of $\hat{Z}$ $3$ is connected the primary winding of the second passive matching transformer $5$, whose secondary winding is connected to the input of the second analog-to-digital converter $7$, whose analog output is connected to the input of the second signal processor $9$ of the measuring block $\underline{A}$. The first passive matching transformer $4$ and the second passive matching transformer $5$ are identical and their conversion ratios are of the order of tens to hundreds. The output $a_{N1}$ of the amplitude of the phasor of the 1st harmonic voltage component at the normal impedance $R_n$ $2$ from the first signal processor $8$ is connected via block $10$ of the calculation $|R_{Nn}|/a_{N1}$, where $|R_{Nn}|$ is the magnitude of the normal impedance at the measuring frequency, with the first input of the first multiplier $11$, to whose second input is connected the output $a_{Z1}$ of the amplitude of the phasor of the 1st harmonic voltage component at the tested impedance $\hat{Z}$ $3$ from the second signal processor $9$ and whose output is connected to the first input of the second multiplier $12$ and the third multiplier $13$. The output $\varphi_{N1}$ of the argument of the phasor of the 1st harmonic voltage component at the normal impedance $R_n$ $2$ from the first signal processor $8$ is connected to the first input of the adder $14$, to the second input of which the output $\varphi_{Z1}$ of the argument of the phasor of the 1st harmonic voltage component at the tested impedance $\hat{Z}$ $3$ is connected from the second signal processor $9$. The third input of the adder $14$ is the input of the constant value $\varphi_{PRNn}$ at the measuring frequency representing the phase deviation of the normal impedance $R_N$ $2$ from the real value. The output of the adder $14$ is connected, on the one hand, to the input of the static functional sine generator $15$, the output of which is connected to the second input of the third multiplier $13$, and, on the other hand, to the input of the static functional cosine generator $16$, the output of which is connected to the second input of the second multiplier $12$. The output $R$ of the magnitude of the real component of the tested impedance $\hat{Z}$ $3$ of the second multiplier $12$ is connected to the first input s of the control timer $17$. The output $X$ of the magnitude of the imaginary component of the tested impedance $\hat{Z}$ $3$ of the third multiplier $13$ is connected to the second input $t$ of the control timer $17$, whose output of signal $\underline{x}$ is connected to the control input of the generator $1$. The output f of the frequency and the system output code generated by converting the signals from the first input s and from the second input $t$ of the control timer $17$ is connected to the output port $\underline{V}$ and is also the output of the device.

The above described basic connection of the small impedances measuring system of Fig. 8 works as follows.

The double pole representing the tested impedance $\hat{Z}$ $3$, whose complex impedance $\hat{Z}$ is measured, is connected into a current loop and the voltage drop on it is monitored. The current supplied by generator $1$ generates voltage drops at the tested impedance $\hat{Z}$ $3$ and normal impedance $R_N$ 2. The voltage at the measured, i.e. tested, impedance $\hat{Z}$ $3$ and the voltage at the normal impedance $R_N$ $2$ are evaluated by two equivalent measuring circuits.

The voltage evaluation circuit at the tested impedance $\hat{Z}$ $3$ is connected to its voltage terminals via the second matching transformer $5$, which allows to reduce the impedance mismatch ratio at the input of the second analog-to-digital converter $7$ and thus improve the signal/noise ratio for the processed signal in a ratio approximately equal to its voltage transformation ratio.

The voltage evaluation circuit at the normal impedance $R_N$ $2$ is connected to its voltage terminals and then through the first matching transformer $4$ to the input of the first analog-to-digital converter $6$.

The voltage evaluation circuit at the normal impedance $R_N$ $2$ is designed with respect to achieving the maximum equivalence of the transmission functions of the measuring and normal circuits, which leads to mutual compensation of their frequency dependence $\hat{F}_\omega$ and elimination of the possible cause of the measurement error.

$$\hat{Z} = \hat{Z}_N \frac{\hat{U}_Z}{\hat{U}_N} = \hat{Z}_N \frac{\hat{F}_\omega \, \hat{U}_Z}{\hat{F}_\omega \, \hat{U}_N}$$

The output digital signals from the first and second analog-to-digital converters 6 and 7 are routed to the inputs of the first and second signal processors 8 and 9, where the sequences of data, showing one to two of their periods, are converted into series representing the signal in the frequency domain. The individual components of the Fourier series are represented in polar form at the outputs of the first and second signal processors 8 and 9, respectively. According to the components at the output of the first signal processor 8 $a_{N1}$ a $\varphi_{N1}$ and the components $a_{Z1}$, $\varphi_{Z1}$ at the output of the second signal processor 9, representing the harmonic signal with the desired measuring frequency, the search impedance is calculated as follows:

$$|Z| = \frac{a_{Z1} * |R_N|}{a_{N1}}$$

$$\varphi = \varphi_{Z1} - \varphi_{N1} - \varphi_{RN}$$

$$R = |Z| \cos\varphi$$

$$X = |Z| \sin\varphi$$

The values $a_{N1}$, showing the amplitude of the phasor of the 1st harmonic component of the voltage at the normal impedance $R_N$ 2 are routed to the first input of block 10 of the calculation $|R_{Nn}|/a_{N1}$, where they are normed by the value of the magnitude of the normal impedance $|R_N|$, recorded, usually as a constant, at the second input. The signal from the output of block 10 of the calculation $|R_{Nn}|/a_{N1}$, representing the inverted value of the amplitude of the current passing through the current loop, is routed to one input of the first multiplier 11, to the second input of which the signal $az_1$ from the output of the second signal processor 9 showing the amplitude of the phasor of the 1st harmonic component of the voltage at the measured impedance $\hat{Z}$ 3 is routed. The signal from the output of the first multiplier 11 representing the magnitude $|\hat{Z}|$ of the monitored tested impedance $\hat{Z}$ 3 is further routed to the 1st inputs of the second multiplier 12 and the third multiplier 13.

The values $\varphi_{N1}$, showing the argument of the phasor of the 1st harmonic component of the voltage at the normal impedance $R_N$ 2, are routed to the first input of the adder 14, to whose second input the signal $\varphi_{Z1}$ is routed from the output of the second signal processor 9.

The third input of the adder 14 is usually supplied with a constant value $\varphi_{RN}$ representing the phase deviation of the normal impedance $R_N$ 2 from the real value. The value $\varphi$ from the output of the adder 14 showing the argument of the phasor $\hat{Z}$ of the tested impedance $\hat{Z}$ 3 is then routed to the input of the static functional cosine generator 16 and to the input of the static functional sine generator 15, from the outputs of which the functional values $\cos\varphi$ and $\sin\varphi$ are routed to the second inputs of the second multiplier 12 and the third multiplier 13, where multiplying with the value representing the magnitude $|\hat{Z}|$ of the monitored measured impedance $\hat{Z}$ 3 calculates the components of the complex impedance. The signal R, representing the magnitude of the real component of the tested impedance $\hat{Z}$ 3, which is the output signal of the second multiplier 12, as well as the output signal of the entire voltage evaluation circuit, is routed to the first input s of the control timer 17. The signal X, representing the magnitude of the imaginary component of the tested impedance $\hat{Z}$ 3, which is the output signal of the third multiplier 13, as well as the output signal of the entire voltage evaluation circuit, is routed to the second input t of the control timer 17, which controls the generator 1 according to the selected algorithm and provides reading of the values of the signals at the inputs. Signals from inputs s, t are converted to the system output code and directed to its output port V.

The principle arrangement of implementation of impedance measuring devices having a constant DC voltage between terminals, such as batteries, is shown in Fig. 9 with schematically indicated measuring block A and Fig. 10 with expanded measuring block A.

The configuration of the device according to this modification consists of a current measuring circuit with the tested battery cell, which forms the tested impedance Z 3, which is connected to the current measuring circuit by its current terminals, the normal impedance $R_N$ 2, which is also connected to the current measuring circuit by its current terminals, limiting resistor 20, the first decoupling capacitor 19 and the output port of the power amplifier 18, which is connected to the excitation generator G 1 by an input port. Furthermore, the wiring includes two equivalent measuring circuits: a voltage evaluation circuit at the measured impedance and a voltage evaluation circuit at the normal impedance $R_N$ 2.

The voltage evaluation circuit at the measured impedance is connected to the voltage terminals b, d of the tested battery cell. To terminal b is connected by its first terminal a second decoupling capacitor 21, which is connected by the second terminal to the switching contact of the first switching system of relay Re 22. The first charging resistor 23 is connected by the first terminal to its opening side, connected by the second terminal to the terminal d of the battery cell forming the tested impedance Z 3. Its magnitude is selected in such a way that the charging and discharging currents of the second decoupling capacitor 21 generated when connecting the test objects to the measuring terminals are limited to tolerable values. Furthermore, the antiparallel connected first limiting diode 24 and the second limiting diode 25 and the primary winding of the second matching transformer 5 at the terminal 2a of the measuring block A are connected by their first terminals to the switching contact of the first switching system of relay Re 22. With their second terminals, these limiting diodes 24 and 25 are connected to the primary winding of the first matching transformer 5 at terminal 2b of the measuring block A, and to terminal d of the battery cell.

The voltage evaluation circuit at the normal impedance $R_N$ 2 is designed with respect to achieving the maximum equivalence of the transmission functions of the measuring and normal circuits, which leads to mutual compensation of their frequency dependence $\hat{F}_\omega$ and elimination of the possible cause of the measurement error.

$$\hat{Z} = \hat{Z}_N \frac{\hat{U}_Z}{\hat{U}_N} = \hat{Z}_N \frac{\hat{F}_\omega}{\hat{F}_\omega} \frac{\hat{U}_Z}{\hat{U}_N}$$

The circuit is connected to the voltage terminals of the normal impedance $R_N$ 2, the second terminal of which is connected to the first terminal of the series-parallel quadruplet 26 of the decoupling capacitors C, which is connected by the middle terminal to the first terminal of the second charging resistor 27, connected by the second terminal to the terminal d of the battery cell $\hat{Z}$ 3, the magnitude of which is selected so that in the steady state there is no significant drop in DC voltage and no significant AC current flowing through it. This quadruplet 26 of decoupling capacitors is connected by the second terminal to the switching contact of the second switching system of relay Re 22, to the opening side of which is connected by the first terminal the third charging resistor 28, connected by the second terminal to the first voltage terminal of the normal impedance. Its magnitude is chosen so that the charging and discharging currents of the decoupling capacitors C of the series-parallel quadruplet 26 generated during the connection of the tested objects to the measuring terminals are limited to the tolerable values. Furthermore, the third limiting diode 29 and the fourth limiting diode 30 and the primary winding of the first matching transformer 4 of the measuring block A are connected in parallel to the switching contact of the second switching system of the relay Re 22 by their first terminals. By their second terminals, these limiting diodes 29 and 30 are connected to the primary winding of the first matching transformer 4 at terminal 1b of the measuring block A and to the first voltage terminal of the normal impedance $R_N$ 2.

The connection of the measuring block A is analogous to the basic circuit according to Fig. 8.

The above described connection of the system for measuring small impedances having a constant DC voltage between the terminals according to Figs. 9 and 10 works as follows.

The tested impedance $\hat{Z}$ 3 is represented by a battery cell, whose complex impedance $\hat{Z}$ is measured. This battery cell is connected to a current loop consisting of this tested impedance Z 3, normal impedance $R_N$ 2, limiting resistor 20 which limits the maximum current in the loop when connecting or disconnecting the cells to be measured also during measurement, the first decoupling capacitor 19 which prevents the flow of direct current through the loop and the output port of the power amplifier 18 which is controlled by the excitation generator G 1 and supplies the measuring current. The current supplied by the power amplifier 18 creates voltage drops at the tested impedance $\hat{Z}$ 3 and the normal impedance $R_N$ 2. The voltage at the measured, i.e. tested, impedance $\bar{Z}3$ and the voltage at the normal impedance $R_N$ 2 are evaluated by two equivalent measuring circuits.

Furthermore, the system function is controlled by relay 22. Without coil current, when the opening sides of the switching contacts are switched on, the circuit controls the charging or discharging of decoupling capacitors 19 and 21 when connecting or disconnecting the measured cells. The second decoupling capacitor 21 and the first charging resistor 23 are connected in series to the live cell. After connection, a transient process takes place in the circuit, which gradually subsides over time and the second decoupling capacitor 21 is charged to the terminal voltage of the cell. At the same time, a series-parallel quadruplet 26 of decoupling capacitors is connected to the live cell in series with the second charging resistor 27, the third charging resistor 28 and the normal impedance $R_N$ 2. When connected, a transient process takes place in the circuit, which gradually subsides over time and the quadruplet 26 of decoupling capacitors are charged to the terminal voltage of the cell.

When the coil of relay 22 is energized, i.e. when the switching sides of the switching contacts are switched on, the circuit allows the AC measuring signal to pass through the small AC impedances of the second decoupling capacitor 21 and the series-parallel quadruplet 26 of capacitors from the voltage terminals of the battery cell, i.e. the tested impedance $\hat{Z}$ 3, as well as from the voltage terminals of the normal impedance $R_N$ 2 to the input terminals 1a, 1b, 2a, 2b of the measuring block A. The signals supplied to the input terminals 1a, 1b, 2a, 2b of the measuring block A are processed in the same way as for the basic wiring according to Fig. 8, where the output signals R and X are generated equally.

In this circuit, a signal from the switch 31 is also directed to the input x of the control timer 17, indicating the state of connection of the cell to be measured and the state when it is not handled with. This signal synchronizes the origin of signal y, which is directed to relay Re 22 and causes it to close.

Furthermore, the control signal f of the generator 1 is generated by the control timer 17, determining the frequency of its output sine signal, possibly correcting the amplitude of this signal, which is directed from the output x of the control timer 17 to the control input of the generator 1 and, in the form of a system output code, to the

output port $\underline{V}$

The signal waveforms at the gates of the control timer $\underline{17}$ during the impedance spectrum measurement are shown in Fig. 11. The measurement of the impedance spectrum starts by a signal from the output of switch $\underline{31,}$ indicating the state of connection of the measured cell by the operator. Subsequently, with a delay corresponding to the subsidence of the transient processes in the decoupling capacitors $\underline{19, 21,}$ and in the quadruplet $\underline{26}$ of decoupling capacitors, a switching signal y is generated at the output $\underline{y}$ of the control timer $\underline{17}$, which is routed to relay $\underline{22}$ and causes it to close. Furthermore, a signal $\underline{f}$ controlling generator $\underline{1}$ is generated at the output x of the control timer $\underline{17}$ at least in terms of the frequency of the generated signal, in a preferred solution also the phase and amplitude of the signal, or its instantaneous value, thereby minimizing the duration of the transient process when the measuring frequency changes. Subsequently, with a delay corresponding to the subsidence of the transient process in the measuring circuit, the control timer $\underline{17}$ receives at its first input s a signal from the output $\underline{R}$ of the magnitude of the real component of the tested impedance $\hat{Z}$ $\underline{3}$ and at its second input $\underline{t}$ the output $\underline{X}$ of the magnitude of the imaginary component of the tested impedance $\hat{Z}$ $\underline{3}$. At the same time, these signals, together with the signal f from the output $\underline{x,}$ are sent by the control timer $\underline{17}$ to its output port $\underline{V}$.

Industrial Applicability

The device is designed for measuring small impedances. Its extended variant is advantageously usable for battery testing by electrochemical impedance spectroscopy, allowing to determine its parameters from the measured dependence of battery impedance on frequency. It is particularly useful for diagnostics of traction accumulators with a capacity of tens to hundreds of Ah, when the impedances of units of mΩ are monitored.

**Reference Signs List**

1 generator
2 normal impedance
3 tested impedance
4 first matching transformer
5 second matching transformer
6 first analog-to-digital converter
7 second analog-to-digital converter
8 first signal processor
9 second signal processor
10 block of calculation $|R_{Nn}|a_{N1}$
11 first multiplier
12 second multiplier
13 third multiplier
14 adder
15 static functional sine generator

16 static functional cosine generator
17 control timer
18 power amplifier
19 first decoupling capacitor
20 limiting resistor
21 second decoupling capacitor
22 relay
23 first charging resistor
24 first limiting diode
25 second limiting diode
26 quadruplet of decoupling capacitors
27 second charging resistor
28 third charging resistor
29 third limiting diode
30 fourth limiting diode
31 switch
A measuring block
B DC component separator
R output of the magnitude of the real component of the tested impedance s first input of the control timer
X output of the magnitude of the imaginary component of tested impedance
x output of the control timer signal
f frequency output
V output port
a second current terminal of the tested impedance
c first current terminal of the tested impedance
b first voltage terminal of the tested impedance
d second voltage terminal of the tested impedance
1a first terminal of the primary winding of the first passive matching transformer
1b second terminal of the primary winding of the first passive matching transformer
2a first terminal of the primary winding of the second passive matching transformer
2b second terminal of the primary winding of the second passive matching transformer
z third input of the timer
y switching signal output
t second input of the control timer

**Claims**

1. A small impedances measuring device containing:

    - a generator (1) of a measuring signal,
    - a normal impedance $R_n$ (2),
    - a tested impedance $\hat{Z}$ (3) and
    - a measuring block (A),
    wherein
    - a series combination of the normal impedance Rn (2) and the tested impedance $\hat{Z}$ (3) connected to the generator (1) in parallel is connected to a measuring block (A), **characterised in that**
    - parallel to the normal impedance $R_n$ (2) is connected the primary winding of a first passive matching transformer (4), whose
- secondary winding is connected to the input of a first analog-to-digital converter (6), wherein

  ○ the first analog-to-digital converter (6) has a digital output connected to the input of a first signal processor (8) and
  ○ parallel to the tested impedance $\hat{Z}$ (3) is connected the primary winding of a second passive matching transformer (5), whose

- secondary winding is connected to the input of a second analog-to-digital converter (7) whose
- digital output is connected to the input of the second signal processor (9),
wherein
- the first passive matching transformer (4) and the second passive matching transformer (5) are identical and
- conversion ratios of the first passive matching transformer (4) and the second passive matching transformer (5) are of the order of tens to hundreds,
- an output ($a_{N1}$) of the amplitude of the phasor of the 1st harmonic component of the voltage at the normal impedance $R_n$ (2) from the first signal processor (8) is connected via a block (10) of calculation $|R_{Nn}|/a_{N1}$, where

  ○ $|R_{Nn}|$ is the magnitude of the normal impedance at a measuring frequency with a first input of a first multiplier (11),
  ○ a second input of the first multiplier (11) is connected to the output ($a_{Z1}$) of the amplitude of the phasor of the 1st harmonic component of the voltage at the tested impedance $\hat{Z}$ (3) from the second signal processor (9) and whose output is connected to the first input of the second multiplier (12) and the third multiplier (13), and

- an output ($\varphi_{N1}$) of the argument of the phasor of the 1st harmonic component of the voltage at the normal impedance $R_n$ (2) from the first signal processor (8) is connected to the first input of an adder (14), wherein
- a second input of the adder (14) is connected to an output ($\varphi_{Z1}$) of the argument of the phasor of the 1st harmonic component of the voltage at the tested impedance $\hat{Z}$ (3) from the second signal processor (9) and
- a third input of the adder (14) is an input of a constant value ($\varphi_{RNn}$) at the measurement frequency representing the phase deviation of the normal impedance $R_N$ (2) from the real value, wherein
- the output of the adder (14) is connected to both

  ○ an input of a static functional sine generator (15) whose output is connected to a second input of the third multiplier (13) and
  ○ an input of a static functional cosine generator (16) whose output is connected to the second input of the second multiplier (12), wherein

- an output (R) of the magnitude of the real component of the tested impedance $\hat{Z}$ (3) of the second multiplier (12) is connected to a first input (s) of a control timer (17) and
- an output (X) of the magnitude of the imaginary component of the tested impedance $\hat{Z}$ (3) of the third multiplier (13) is connected to a second input (t) of the control timer (17),
- a signal output (x) of the control timer (17) is connected to the control input of the generator (1), wherein
- an output (f) of the frequency and system output code generated by converting the signals from the first input (s) and the second input (t) of the control timer (17) is connected to an output port (V) and is an output of the small impedances measuring device.

2. The small impedances measuring device according to claim 1, **characterized in that** for measuring impedances having a constant DC voltage between terminals, an input of a power amplifier (18) is connected to the generator (1), the output port of which is connected on one hand to the current terminals (a, c) of the tested impedance $\hat{Z}$ (3), and on the other hand via the first decoupling capacitor (19) and the limiting resistor (20) to the current terminals of the normal impedance $R_N$ (2), where to the voltage terminals of the tested impedance $\hat{Z}$ (3) and to the voltage terminals of the normal impedance $R_N$ (2) a DC component separator (B) is connected, upstream the measuring block (A), comprising two equivalent measuring circuits, namely a voltage evaluation circuit at the normal impedance $R_N$ (2) and a voltage evaluation circuit at the tested impedance $\hat{Z}$ (3), where in the circuit of voltage evaluation at the tested impedance Z (3) one terminal of the second decoupling capacitor (21) is connected to the first voltage terminal (b) of the tested impedance $\hat{Z}$ (3), the second terminal of which is connected to the first switching contact of the relay (22), to the opening side of which is connected by one terminal the first charging resistor (23), the second terminal of which is connected to the second voltage terminal (d) of the tested impedance $\hat{Z}$ (3) between which and the switching side of the switching contact of the relay (22) are connected antiparallel connected limiting diodes, the first limiting diode (24) and the second limiting diode (25), which are connected in parallel to the first terminal (2a) and to the second terminal (2b) of the primary winding of the second passive matching transformer (5) of the measuring block (A) and, in the voltage evaluation circuit $R_N$ (2), one voltage terminal of the normal impedance $R_N$ (2) is connected to the first terminal of a series-parallel quadruplet (26) of decoupling capacitors (C), which is connected by the middle terminal via the second charging resistor (27) to the second voltage terminal (d) of the tested impedance $\hat{Z}$ (3) and by the other terminal it is connected to the second switching contact of the relay (22), to the opening side of which the third charging resistor (28) is connected by one terminal, the other terminal of which is connected to the second voltage terminal of the normal impedance $R_N$ (2), between which and the switching side of the switching contact of the relay (22) are connected antiparallel connected limiting diodes, a third limiting diode (29) and a fourth limiting diode (30), which are connected in parallel to the terminals (1a, 1b) of the primary winding of the first passive matching transformer (4) of the measuring block (A), wherein the output (z) of the control switch (31) is connected to the third input of the control timer (17) and the output (y) of the switching signal thereof is connected to the coil of the relay (22).

**Patentansprüche**

1. Vorrichtung zur Messung kleiner Impedanzen, enthaltend

    - einen Generator (1) eines Messsignals,
    - eine Normalimpedanz $R_n$ (2),
    - eine zu prüfende Impedanz $\hat{Z}$ (3) und
    - einen Messblock (A), wobei
    - eine parallel an den Generator (1) angeschlossene Reihenschaltung aus der Normalimpedanz $R_n$ (2) und der zu prüfenden Impedanz $\hat{Z}$ (3) an den Messblock (A) angeschlossen ist, **dadurch gekennzeichnet, dass**
    - parallel zur Normalimpedanz $R_n$ (2) eine Primärwicklung eines ersten passiven Anpassungstransformators (4) angeschlossen ist, dessen
    - Sekundärwicklung mit einem Eingang eines ersten Analog-Digital-Wandlers (6) verbunden ist, wobei

        ○ der erste Analog-Digital-Wandler (6) einen digitalen Ausgang aufweist, der mit einem Eingang eines ersten Signalprozessors (8) verbunden ist, und
        ○ parallel zur zu prüfenden Impedanz $\hat{Z}$ (3) eine Primärwicklung eines zweiten passiven Anpassungstransformators (5) angeschlossen ist, dessen

    - Sekundärwicklung mit einem Eingang eines zweiten Analog-Digital-Wandlers (7) verbunden ist, dessen
    - digitaler Ausgang mit einem Eingang eines zweiten Signalprozessors (9) verbunden ist, wobei
    - der erste passive Anpassungstransformator (4) und der zweite passive Anpassungstransformator (5) identisch sind und
    - die Übersetzungsverhältnisse des ersten passiven Anpassungstransformators (4) und des zweiten passiven Anpassungstransformators (5) in der Größenordnung von Zehnern bis Hunderten liegen,
    - wobei der Ausgang ($a_{N1}$) der Amplitude des Phasors der 1. harmonischen Spannungskomponente an der Normalimpedanz $R_n$ (2) aus dem ersten Signalprozessor (8) über einen Block (10) zur Berechnung von $|R_{Nn}|/a_{N1}$ verbunden ist, wobei

        ○ $|R_{Nn}|$ die Größe der Normalimpedanz bei der Messfrequenz ist, und zwar mit einem ersten Eingang eines ersten Multiplizierers (11),
        ○ wobei an den zweiten Eingang des Multiplizierers (11) der Ausgang ($a_{Z1}$) der Amplitude des Phasors der 1. harmonischen Spannungskomponente an der zu prüfenden Impedanz $\hat{Z}$ (3) aus dem zweiten Signalprozessor (9) angeschlossen ist und dessen Ausgang mit einem ersten Eingang eines zweiten Multiplizierers (12) und eines dritten Multiplizierers (13) verbunden ist, und ferner

    - der Ausgang ($\varphi_{N1}$) des Arguments des Phasors der 1. harmonischen Spannungskomponente an der Normalimpedanz $R_n$ (2) aus dem ersten Signalprozessor (8) mit einem ersten Eingang eines Addierers (14) verbunden ist, wobei
    - an einen zweiten Eingang des Addierers (14) der Ausgang ($\varphi_{Z1}$) des Arguments des Phasors der 1. harmonischen Spannungskomponente an der zu prüfenden Impedanz $\hat{Z}$ (3) aus dem zweiten Signalprozessor (9) angeschlossen ist und
    - ein dritter Eingang des Addierers (14) ein Eingang eines konstanten Wertes ($\varphi_{RNn}$) bei der Messfrequenz ist, der die Phasenabweichung der Normalimpedanz $R_N$ (2) von einem reellen Wert repräsentiert, wobei
    - der Ausgang des Addierers (14) einerseits

        ○ mit einem Eingang eines statischen Sinus-Funktionsgenerators (15), dessen Ausgang mit einem zweiten Eingang des dritten Multiplizierers (13) verbunden ist, und andererseits

◦ mit einem Eingang eines statischen Kosinus-Funktionsgenerators (16), dessen Ausgang mit einem zweiten Eingang des zweiten Multiplizierers (12) verbunden ist, verbunden ist, wobei

- der Ausgang (R) der Größe der reellen Komponente der zu prüfenden Impedanz $\hat{Z}$ (3) des zweiten Multiplizierers (12) mit einem ersten Eingang (s) eines Steuerzeitgebers (17) verbunden ist und
- der Ausgang (X) der Größe der imaginären Komponente der zu prüfenden Impedanz $\hat{Z}$ (3) des dritten Multiplizierers (13) mit einem zweiten Eingang (t) des Steuerzeitgebers (17) verbunden ist, und
- ein Ausgang (x) eines Signals des Steuerzeitgebers (17) mit einem Steuereingang des Generators (1) verbunden ist, wobei
- ein Ausgang (f) der Frequenz und ein Ausgangscode des Systems, der durch Konvertieren der Signale aus dem ersten Eingang (s) und dem zweiten Eingang (t) des Steuerzeitgebers (17) gebildet wird, mit einem Ausgangsport (V) verbunden sind und den Ausgang der Vorrichtung zur Messung kleiner Impedanzen bilden.

2. Vorrichtung zur Messung kleiner Impedanzen nach Anspruch 1, **dadurch gekennzeichnet, dass** zum Messen von Impedanzen, die zwischen den Klemmen eine konstante Gleichspannung aufweisen, an den Generator (1) ein Eingang eines Leistungsverstärkers (18) angeschlossen ist, dessen Ausgangsport einerseits mit Stromklemmen (a, c) der zu prüfenden Impedanz $\hat{Z}$ (3) und andererseits über einen ersten Trennkondensator (19) und einen Begrenzungswiderstand (20) mit Stromklemmen der Normalimpedanz $R_N$ (2) verbunden ist, wobei an Spannungsklemmen der zu prüfenden Impedanz $\hat{Z}$ (3) und an Spannungsklemmen der Normalimpedanz $R_N$ (2) vor dem Messblock (A) eine Einrichtung (B) zur Abtrennung des Gleichanteils angeschlossen ist, die zwei äquivalente Messschaltungen bildet, nämlich eine Schaltung zur Auswertung der Spannung an der Normalimpedanz $R_N$ (2) und eine Schaltung zur Auswertung der Spannung an der zu prüfenden Impedanz $\hat{Z}$ (3), wobei bei der Schaltung zur Auswertung der Spannung an der zu prüfenden Impedanz $\hat{Z}$ (3) an eine erste Spannungsklemme (b) der zu prüfenden Impedanz $\hat{Z}$ (3) eine Klemme eines zweiten Trennkondensators (21) angeschlossen ist, dessen zweite Klemme mit einem ersten Umschaltkontakt eines Relais (22) verbunden ist, an dessen Öffnerseite mit einer Klemme ein erster Ladewiderstand (23) angeschlossen ist, dessen zweite Klemme mit einer zweiten Spannungsklemme (d) der zu prüfenden Impedanz $\hat{Z}$ (3) verbunden ist, wobei zwischen dieser zweiten Spannungsklemme (d) und der Schließerseite des Umschaltkontakts des Relais (22) antiparallel geschaltete Begrenzungsdioden, nämlich eine erste Begrenzungsdiode (24) und eine zweite Begrenzungsdiode (25), angeschlossen sind, die parallel an eine erste Klemme (2a) und eine zweite Klemme (2b) der Primärwicklung des zweiten passiven Anpassungstransformators (5) des Messblocks (A) angeschlossen sind, und bei der Schaltung zur Auswertung der Spannung an der Normalimpedanz $R_N$ (2) eine Spannungsklemme der Normalimpedanz $R_N$ (2) mit einer ersten Klemme einer serienparallelen Viereranordnung (26) von Trennkondensatoren (C) verbunden ist, die mit einer mittleren Klemme über einen zweiten Ladewiderstand (27) mit der zweiten Spannungsklemme (d) der zu prüfenden Impedanz $\hat{Z}$ (3) verbunden ist und mit einer zweiten Klemme mit einem zweiten Umschaltkontakt des Relais (22) verbunden ist, an dessen Öffnerseite mit einer Klemme ein dritter Ladewiderstand (28) angeschlossen ist, dessen zweite Klemme mit der zweiten Spannungsklemme der Normalimpedanz $R_N$ (2) verbunden ist, wobei zwischen dieser zweiten Spannungsklemme und der Schließerseite des Umschaltkontakts des Relais (22) antiparallel geschaltete Begrenzungsdioden, nämlich eine dritte Begrenzungsdiode (29) und eine vierte Begrenzungsdiode (30), angeschlossen sind, die parallel an die Klemmen (1a, 1b) der Primärwicklung des ersten passiven Anpassungstransformators (4) des Messblocks (A) angeschlossen sind, wobei an einen dritten Eingang des Steuerzeitgebers (17) ein Ausgang (z) eines Steuerschalters (31) angeschlossen ist und dessen Ausgang (y) eines Schaltsignals mit einer Spule des Relais (22) verbunden ist.

**Revendications**

1. Dispositif de mesure de faibles impédances comprenant

- un générateur (1) de signal de mesure,
- l'impédance de référence $R_n$ (2),
- l'impédance testée $\hat{Z}$ (3) et
- un bloc de mesure (A),
- la combinaison en série de l'impédance de référence $R_n$ (2) et de l'impédance testée $\hat{Z}$ (3) raccordée en parallèle au générateur (1) est raccordée au bloc de mesure (A),
**caractérisé en ce que**
- l'enroulement primaire du premier transformateur d'adaptation passif (4) est raccordé en parallèle à l'impédance de référence $R_n$ (2), dont
- l'enroulement secondaire est relié à l'entrée du premier convertisseur analogique-numérique (6),

◦ le premier convertisseur analogique-numérique (6) ayant une sortie numérique reliée à l'entrée du premier processeur de signal (8) et

◦ l'enroulement primaire du deuxième transformateur d'adaptation passif (5) étant raccordé en parallèle à l'impédance testée $\hat{Z}$(3), dont

- l'enroulement secondaire est relié à l'entrée du deuxième convertisseur analogique-numérique (7), dont

- la sortie numérique est reliée à l'entrée du deuxième processeur de signal (9),

- le premier transformateur d'adaptation passif (4) et le deuxième transformateur d'adaptation passif (5) étant identiques et

- les rapports de transformation du premier transformateur d'adaptation passif (4) et du deuxième transformateur d'adaptation passif (5) sont de l'ordre de quelques dizaines à quelques centaines,

- la sortie ($a_{N1}$) de l'amplitude du phaseur de la 1re composante harmonique de la tension sur l'impédance de référence $R_n$ (2) provenant du premier processeur de signal (8) est reliée via le bloc (10) de calcul $|R_{Nn}|/a_{N1}$, où

◦ $|R_{Nn}|$ est la valeur de l'impédance de référence à la fréquence de mesure avec la première entrée du premier multiplicateur (11),

◦ à la deuxième entrée du multiplicateur (11) est raccordée la sortie ($aZ1$) de l'amplitude du phaseur de la 1re composante harmonique de la tension sur l'impédance testée $\hat{Z}$ (3), provenant du deuxième processeur de signal (9), et dont la sortie est reliée à la première entrée du deuxième multiplicateur (12) et du troisième multiplicateur (13), et

- la sortie ($\varphi_{N1}$) de l'argument du phaseur de la 1re composante harmonique de la tension sur l'impédance de référence $R_n$ (2) provenant du premier processeur de signal (8) est reliée à la première entrée de l'additionneur (14),

- à la deuxième entrée de l'additionneur (14) est raccordée la sortie ($\varphi_{Z1}$) de l'argument du phaseur de la 1re composante harmonique de la tension sur l'impédance testée $\hat{Z}$ (3), provenant du deuxième processeur de signal (9), et

- la troisième entrée de l'additionneur (14) est l'entrée d'une valeur constante ($\varphi_{RNn}$) à la fréquence de mesure, représentant l'écart de phase de l'impédance de référence $R_N$ (2) par rapport à la valeur réelle, où

- la sortie de l'additionneur (14) est reliée d'une part

◦ à l'entrée du générateur de fonction sinus statique (15), dont la sortie est reliée à la deuxième entrée du troisième multiplicateur (13), et d'autre part

◦ à l'entrée du générateur de fonction cosinus statique (16), dont la sortie est reliée à la deuxième entrée du deuxième multiplicateur (12),

- la sortie (R) de la composante réelle de l'impédance testée $\hat{Z}$ (3) du deuxième multiplicateur (12) étant reliée à la première entrée (s) du temporisateur de commande (17) et

- la sortie (X) correspondant à l'amplitude de la composante imaginaire de l'impédance testée $\hat{Z}$(3) du troisième multiplicateur (13) étant reliée à la deuxième entrée (t) du temporisateur de commande (17), et

- la sortie (x) du signal du temporisateur de commande (17) étant reliée à l'entrée de commande du générateur (1),

- la sortie (f) de la fréquence et le code de sortie du système, générés par la conversion des signaux provenant de la première entrée (s) et de la deuxième entrée (t) du temporisateur de commande (17) étant relié au port de sortie (V) et constitue la sortie du dispositif de mesure de faibles impédances.

2. Dispositif de mesure de faibles impédances selon la revendication 1, **caractérisé en ce que,** pour mesurer des impédances présentant une tension continue constante entre les bornes, l'entrée d'un amplificateur de puissance (18) est raccordée au générateur (1), dont le port de sortie est relié d'une part aux bornes de courant (a, c) de l'impédance testée $\hat{Z}$ (3) et, d'autre part, via un premier condensateur d'isolement (19) et une résistance de limitation (20) aux bornes de courant de l'impédance de référence $R_N$ (2), où un bloc de mesure (A) est raccordé aux bornes de tension de l'impédance testée $\hat{Z}$ (3) et aux bornes de tension de l'impédance de référence $R_N$ (2), un séparateur (B) de composante continue, qui forme deux circuits de mesure équivalents, à savoir un circuit d'évaluation de la tension sur l'impédance de référence $R_N$ (2) et un circuit d'évaluation de la tension sur l'impédance testée $\hat{Z}$ (3), où, dans le circuit d'évaluation de la tension sur l'impédance testée $\hat{Z}$ (3), une borne du deuxième condensateur d'isolement (21) est raccordée à la première borne de tension (b) de l'impédance testée $\hat{Z}$(3), dont la deuxième borne est raccordée au premier contact inverseur du relais (22), au côté d'ouverture duquel est raccordée, au moyen d'une borne, la première résistance de charge (23), dont la deuxième borne est reliée à la deuxième borne de tension (d) de l'impédance testée $\hat{Z}$(3), entre laquelle et le côté de fermeture du contact inverseur du relais (22) sont raccordées en antiparallèle des diodes de limitation, à savoir la première diode de limitation (24) et la deuxième diode de limitation (25), qui sont raccordées en parallèle à la première borne (2a) et à la deuxième borne (2b) de l'enroulement primaire du deuxième transformateur d'adaptation passif (5) du bloc de mesure (A) et, dans le circuit d'évaluation de la tension sur l'impédance de référence $R_N$ (2), une borne de tension de l'impédance de référence $R_N$ (2) est reliée à la première borne d'un quadruplet série-parallèle (26) de condensateurs d'isolement (C), dont la borne centrale est reliée, via une deuxième résistance de charge (27), à la deuxième borne de tension (d) de l'impédance testée $\hat{Z}$ (3), et dont la deuxième borne est reliée au deuxième contact inverseur du relais (22), dont le côté d'ouverture est relié, par une borne, à la troisième résistance de charge (28), dont la deuxième borne est reliée à la deuxième borne de tension de l'impédance de référence $R_N$ (2), entre laquelle et le côté de fermeture du contact inverseur du relais (22) sont raccordées, en antiparallèle, des diodes de limitation, une troisième diode de limitation (29) et une quatrième diode de limitation (30), qui sont raccordées en parallèle aux bornes (1a, 1b) de l'enroulement primaire du premier transformateur d'adaptation passif (4) du bloc de mesure (A), la sortie (z) de l'interrupteur de commande (31) étant reliée à la troisième entrée du temporisateur de commande (17), et sa sortie (y) de signal de commutation étant reliée à la bobine du relais (22).

Fig. 1A    Fig. 1B    Fig. 1C

Fig. 2

Fig. 3A    Fig. 3B    Fig. 3C    Fig. 3D

$$\hat{Z} = R + \frac{j}{\omega C}$$

$$\hat{Z}_x = \hat{Z}_1^l - \hat{Z}_1$$

Fig. 4

Fig. 5A          Fig. 5B

Fig. 6

Fig. 7

Fig. 8.

**Fig. 9**

**Fig. 10**

**Fig. 11**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 309064 A
- WO 80036 A

- US 2024027533 A1

**Non-patent literature cited in the description**

- *Novel online fitting algorithm for impedance-based state estimation of Li-ion Batteries, Conference Paper*, October 2019